Europäisches Patentamt

European Patent Office

Office européen des brevets

(11) Numéro de publication : **0 142 400**
**B1**

# (12) FASCICULE DE BREVET EUROPÉEN

(45) Date de publication du fascicule du brevet :
**11.11.87**

(21) Numéro de dépôt : **84401912.5**

(22) Date de dépôt : **26.09.84**

(51) Int. Cl.⁴ : **H 05 K 7/20**, H 01 C 1/084

(54) Boîtier pour composant électronique destiné notamment à la protection téléphonique.

(30) Priorité : **27.09.83 FR 8315337**

(43) Date de publication de la demande :
**22.05.85 Bulletin 85/21**

(45) Mention de la délivrance du brevet :
**11.11.87 Bulletin 87/46**

(84) Etats contractants désignés :
**DE GB IT NL**

(56) Documents cités :
**GB-A- 2 019 653**
**US-A- 3 988 709**
**US-A- 3 996 447**

(73) Titulaire : **COMPAGNIE EUROPEENNE DE COMPO-
SANTS ELECTRONIQUES LCC
50, rue Jean - Pierre Timbaud B.P. 301
F-92402 Courbevoie (FR)**

(72) Inventeur : **Grandjean, Daniel THOMSON-CSF
SCPI 173, bld Haussmann
F-75379 Paris Cedex 08 (FR)**
Inventeur : **Cavuoto, Roger THOMSON-CSF
SCPI 173, bld Haussmann
F-75379 Paris Cedex 08 (FR)**

(74) Mandataire : **Ruellan-Lemonnier, Brigitte et al
THOMSON-CSF SCPI 19, avenue de Messine
F-75008 Paris (FR)**

Jouve, 18, rue St-Denis, 75001 Paris, France

## Description

La présente invention concerne un boîtier pour composant électronique comportant deux faces planes opposées revêtues d'électrodes, ledit boîtier comportant un capot et une embase traversés par au moins un premier et un deuxième contacts électriques, l'extrémité desdits contacts situés dans le boîtier étant destinée à être reliée respectivement à une électrode du composant, voir p. ex. US-A-3 988 709.

Les lignes téléphoniques sont le siège de perturbations électriques intenses dues aux décharges atmosphériques ainsi qu'aux liaisons galvaniques directes ou induites avec une ligne de distribution d'énergie électrique. Il s'est donc avéré nécessaire de les protéger à la fois contre les surtensions et les surintensités pouvant entraîner le destruction du central ou du combiné téléphonique de l'abonné.

La façon la plus habituelle de réaliser le câblage des circuits de protection téléphonique est de faire appel à des composants discrets connectés par soudure sur la carte imprimée des circuits à protéger. Cette manière de faire présente cependant un certain nombre d'inconvénients :

le couplage thermique entre les différents composants qui permet, dans bien des cas, ainsi qu'on le verra par la suite, d'améliorer le fonctionnement de ces circuits, est très difficile à réaliser sur cette carte imprimée,

les composants discrets utilisés doivent posséder des fils de connexion, ce qui n'est pas le cas d'un certain nombre de composants tels que les résistances à coefficient de température très souvent utilisées dans ces circuits. Ce type de résistance est généralement réalisée sous forme d'un disque avec des métallisations en aluminium sur les deux faces circulaires opposées. La solution serait alors de souder directement un tel composant sur le circuit mais ceci nécessite l'utilisation de soudure à bas point de fusion pour ne pas endommager celui-ci. Par conséquent, on limite alors l'utilisation des résistances à coefficient de température fonctionnant à basse température.

Le brevet français 2 494 925 décrit un composant pour la protection téléphonique constitué essentiellement d'une résistance à coefficient de température positif et d'une varistance couplée thermiquement. Outre le fait qu'un tel composant présente une capacité parasite importante du fait de la réalisation par deux disques accolés, aucune solution n'est donnée dans ce brevet quant à la connexion des éléments entre eux, leur disposition dans un boîtier, en particulier pour obtenir un composant qui à l'intérieur de son boîtier possède de faibles caractéristiques d'encombrement, compte tenu des contraintes imposées par les constructeurs de matériel téléphonique.

Le boîtier selon l'invention permet de résoudre les différents problèmes posés ci-dessus. Dans ce but, il est caractérisé en ce que ledit contact électrique comporte une extrémité extérieure au boîtier assurant la dissipation thermique par convection de la chaleur par le composant, l'autre partie des contacts électriques assurant la conduction thermique, de ladite chaleur jusqu'à ladite extrémité inférieure.

De préférence, les deux contacts, disposés verticalement, traversent l'embase sensiblement à 90° l'un par rapport à l'autre, le premier contact destiné au contact avec l'électrode inférieure du composant comportant une partie en H, les deux bras inférieurs du H constituant les pattes de connexion du contact, ledit premier contact comportant en outre en son milieu une partie sensiblement horizontale venant s'appuyer sur le fond de l'embase du boîtier, tandis que le second contact destiné au contact avec l'électrode supérieure du composant est un contact élastique pourvu de plusieurs doigts.

Selon un mode préférentiel de réalisation, le fond de l'embase possède une ouverture permettant la dissipation de la chaleur par le verso de la partie horizontale du premier contact, ladite embase pouvant être en matériau dont la température de ramollissement est inférieure à la température de fonctionnement maximal du composant. La forme de cette partie horizontale du second contact, correspond au logement réalisé dans l'embase et permet le maintien dans un plan horizontal dudit contact.

L'invention sera mieux comprise à l'aide des exemples de réalisation suivants, donnés à titre non limitatif, conjointement avec les figures qui représentent :

la figure 1, un premier exemple de réalisation d'un boîtier selon l'invention comportant un élément sous forme de disque,

la figure 2, un second exemple de réalisation d'un boîtier selon l'invention comportant deux composants sous forme de disque.

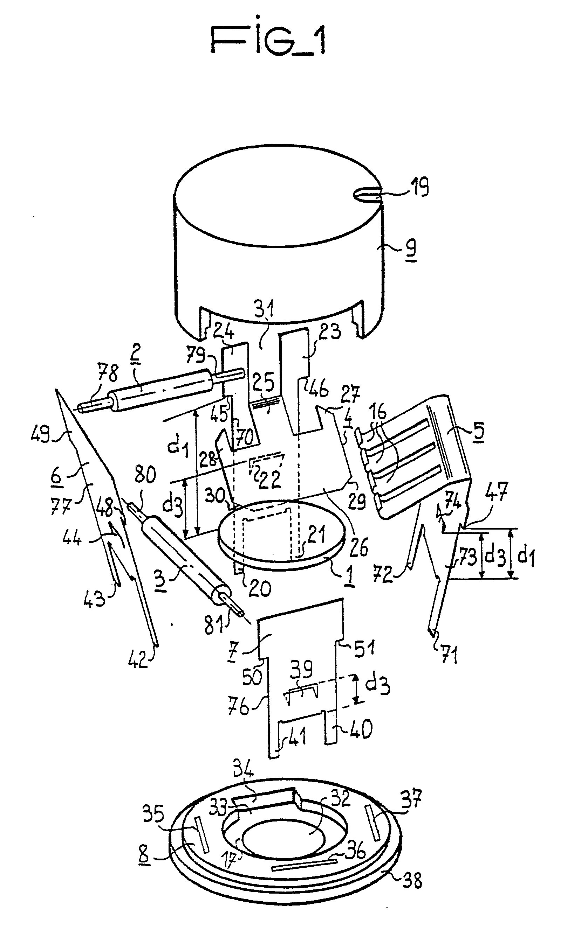

Sur la figure 1, est représentée une vue éclatée d'un premier mode de réalisation d'un boîtier selon l'invention. Ce boîtier comporte une embase 8, un capot 9 et quatre contacts électriques 4 et 5, 6 et 7. Les contacts 4 et 5 sont destinés à la connexion du composant 1 dont la caractéristique est de posséder deux faces planes opposées munies d'électrodes (non représentées sur la figure). Sur cette figure, ce composant 1 a la forme d'un disque. Le premier contact 4 comporte une partie verticale en forme de H et une partie horizontale raccordée à la précédente entre les deux bras supérieurs du H. Ce contact présente la particularité d'être découpée à partir d'une seule pièce puis pliée à 90°. La partie verticale comporte, sur sa portion inférieure, les deux bras inférieurs du H, 20 et 21 destinés à la connexion électrique sur circuit imprimé. Il se prolonge par un corps de contact 70 sensiblement rectangulaire, comportant une découpe élastique 22 destinée au maintien du contact dans un plan vertical après passage dans l'ouverture 34 de l'embase 8. La partie supérieure de celle-ci est située à une hauteur $D_3$ à partir de la base des deux bras inférieurs du H, cette hauteur $D_3$ déterminant la surface de dissipation thermique à l'extérieur du boîtier dudit contact 4. Les deux bras supérieurs 23 et 24 de la partie verticale en forme de H comportent sur leurs portions extérieures deux rebords 45 et 46 venant en butée contre l'embase 8. La partie horizontale du contact 4 est reliée à la partie verticale par la portion 25 de largeur et hauteur correspondant exactement à l'espace 31 situé entre les deux branches 23 et 24. Il se prolonge par une partie 26 venant en contact électrique et thermique avec l'électrode inférieure du composant 1. Cette partie 26 est limitée extérieurement par les portions 27, 28, 29 et 30 délimitant un diamètre sensiblement égal à celui de la rainure interne 17 de l'embase 8, ceci afin de limiter le déplacement horizontal du contact une fois celui-ci fixé dans l'embase 8. Disposé à 90° par rapport au premier contact 4, se trouve le second contact 5 dont la partie inférieure est identique à la partie inférieure de la partie verticale en forme de H du premier contact. Il comporte donc deux pattes de connexion 71, 72, un corps 73 destiné à la dissipation thermique à l'extérieur de l'embase 8, un dispositif de maintien élastique 74 identique à 22, ainsi que sur sa partie supérieure deux rebords 47 (un seul est représenté sur la figure) venant s'appuyer sur l'embase 8 après insertion du contact 5 dans la fente 37 de ladite embase 8. La partie supérieure de ce second contact 5 comporte un premier pli rectangulaire 75 sensiblement à 90° du corps du contact 5, ladite partie rectangulaire se prolongeant par une pluralité de doigts élastiques 16 (quatre doigts sont représentés sur la figure). Ces doigts sont inclinés dans l'exemple représenté ici sensiblement à 30° environ par rapport à l'horizontal. Chaque doigt élastique est indépendant du doigt voisin et son inclinaison et la longueur de chacun des doigts est telle qu'en l'absence du composant 1 destiné à être connecté électriquement et thermiquement entre les deux contacts 4 et 5, il n'existe pas de contact électrique entre le premier contact 4 et le second contact 5. Ceci est une caractéristique de réalisation de l'invention, permettant en cas de pulvérisation due à une surtension ou surintensité du composant 1 de permettre à l'ensemble de se comporter comme un interrupteur ouvert.

Le boîtier pour composant selon l'invention comporte également dans le cas présent (mais ceci n'est pas indispensable, seul le premier et le second contacts l'étant) un troisième et un quatrième contacts respectivement 6 et 7 de forme identique. Ces contacts possèdent une forme sensiblement identique à la partie verticale du premier contact 4, à savoir deux pattes de connexion 40, 41, 42, 43, un corps 76, 77 dont la partie inférieure de hauteur $D_3$ permet la dissipation thermique à l'extérieur du boîtier, et comportant un moyen de fixation élastique 39, 44, permettant de maintenir le contact en position verticale, après passage de celui-ci dans la fente correspondante 36, 35 de l'embase 8. La partie supérieure de ces contacts comporte des épaulements 50, 51, 48, 49, lesdits épaulements venant également en butée contre les parois de l'embase adjacentes aux fentes 36 et 35. La partie supérieure de ces contacts 6 et 7 prend une forme quelconque, permettant le raccordement éventuel de composants tels que 2 et 3 qui comportent des pattes de connexion externes 78, 79, 80, 81 reliant respectivement dans le cas présent le premier contact 4 au contact 6 et ce dernier au contact 7. Ces éléments 2 et 3 peuvent être soit des éléments semi-conducteurs (du type diode, du thyristor, etc...), ou des éléments passifs tels que varistances, résistances, etc...

Il est à noter également que la portion de contacts de hauteur $D_3$ qui a une fonction de dissipation thermique des calories engendrées par le composant 1 a également une seconde fonction de pied de lavage facilitant le lavage du circuit imprimé après soudure du boîtier avec ces composants sur ledit circuit. On notera également que le boîtier selon l'invention permet un couplage thermique entre les composants tels que 1 et les composants tels que 2 et 3, compte tenu du fait que ceux-ci sont toujours disposés sensiblement à la même distance l'un de l'autre. Inversement, on peut prévoir une rondelle d'isolant thermique telle qu'une feuille d'amiante, par exemple, entre le composant 1 et les composants 2 et 3.

Les éléments de contact 4, 5, 6, 7 seront en métaux tels que le bronze béryllium, l'inox, etc... de manière à assurer une bonne conductivité électrique en même temps qu'un pouvoir élastique. Dans ce but, ils sont choisis d'épaisseur faible (de préférence de 1 à 4/10 mm, de manière à ne pas présenter d'inertie thermique importante, ce qui pourrait ralentir les temps de commutation du circuit les utilisant. Par ailleurs, la largeur de ces contacts (sensiblement identique à la largeur des fentes tels que 35, 36, 37, 34) sera importante de manière à ce que lesdits contacts présentent de larges surfaces pour le contact électrique avec les différents composants et pour assurer une bonne dissipation thermique des calories engendrées par le composant 1, en particulier dans leurs parties de hauteur $D_1$, $D_2$, et $D_3$. Cette dissipation thermique par les parties de contact de hauteur $D_3$ en particulier, hors des boîtiers, permettent d'abaisser la température desdits contacts au niveau des pattes de connexion telles que 20, 21, 71, 72, etc... De cette manière, le composant sous forme de disque 1 peut ainsi fonctionner à une température élevée voisine de 200° sans risque de voir lesdites pattes de connexion se dessouder du circuit imprimé d'utilisation, même en utilisant une soudure étain-plomb à point de fusion relativement bas.

La présence de deux pattes de connexion 20 et 21 permet d'une part de renforcer la qualité de fixation de circuit imprimé et d'autre part de réduire la densité de courant en cas de surcharge.

Selon une variante de réalisation, le contact inférieur 4, en particulier dans sa partie horizontale 26, peut être réalisé en métal du type connu sous l'appellation « métal déployé », permettant d'augmenter le nombre de points de contact du fait du relief de celui-ci.

L'ouverture 32 dans l'embase 8, représentée ici sous forme d'une ouverture cylindrique sensiblement au centre du logement cylindrique 17 dans l'embase 8, permet d'éviter le ramollissement de la matière plastique de l'embase (lorsque ladite embase est en matière plastique bien entendu) au contact du composant 1 qui peut ainsi fonctionner à des températures atteignant 200 °C. Enfin, un repère 19 placé sur le capot 9 du boîtier permet le repérage extérieur dudit boîtier dans le cas d'insertion automatique à l'aide d'une machine adéquate.

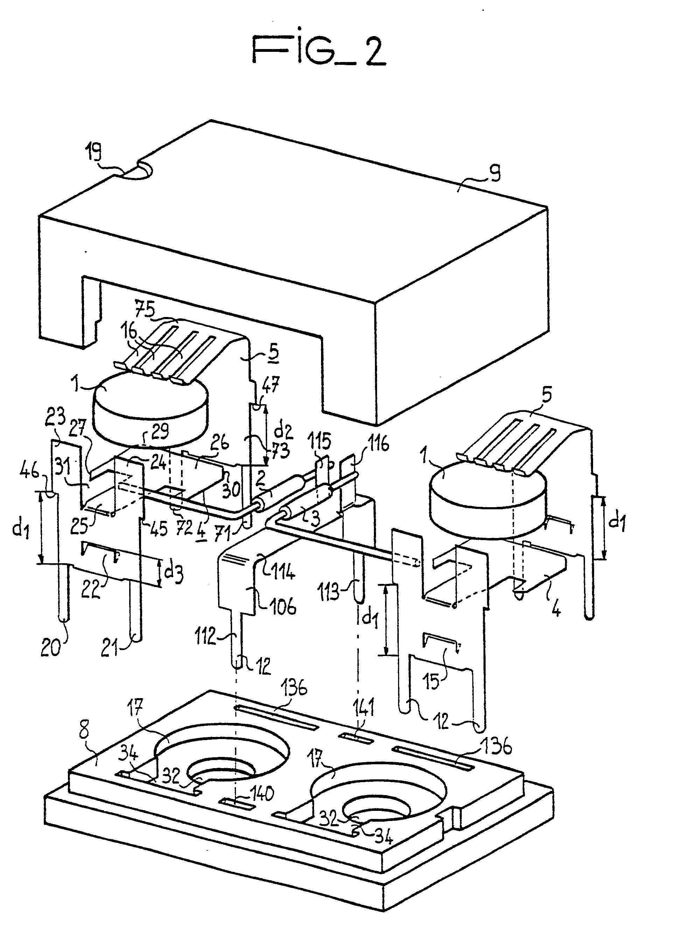

La figure 2 représente un second exemple de réalisation d'un boîtier selon l'invention, boîtier dans lequel sont disposés deux ensembles de contacts pour composant sous forme de disque tel qu'une résistance à coefficient de température positif CTP. Sur cette figure, les mêmes éléments que ceux de la figure précédente, portent les mêmes références. L'embase 8 et le boîtier 9 sont ici de forme rectangulaire compte tenu de la présence de deux ensembles premier et deuxième contacts 4 et 5, disposés côte à côte. Les contacts 4 et 5 de chaque ensemble sont en tous points identiques à ceux décrits sur la figure précédente, ainsi que les alvéoles 17 situées dans l'embase 8, lesdites alvéoles 17 ayant, là encore, une forme type trou de serrure comme sur la figure précédente, avec l'ouverture 32 débouchant sur la face inférieure de l'embase. Entre ces deux couples de contacts 4 et 5, on a disposé un troisième contact 106 de forme différente de celle des troisième et quatrième contacts de la figure précédente. Ici, le contact 106 comporte simplement deux pattes de connexion 112, 113, reliées entre elles à l'intérieur du boîtier par une portion plane 114 sur laquelle sont disposés deux bras 115 et 116 sensiblement perpendiculairement et vers le haut. Ces deux bras sont destinés à la connexion de composants tels que 2 et 3 tel qu'envisagé dans la description de la figure 1. Bien entendu, comme dans l'exemple précédent, ce contact 106 n'est pas nécessaire si l'on veut utiliser uniquement un ou deux composants du type disque muni d'électrodes.

## Revendications

1. Boîtier pour composant électronique (1) comportant deux faces planes opposées revêtues d'électrodes, ledit boîtier comportant une embase (8) et un capot (9), ladite embase (8) étant traversée par au moins un premier et un deuxième contacts électriques (4, 5), l'extrémité desdits contacts située dans le boîtier étant destinée à être reliée respectivement à une électrode du composant (1), caractérisé en ce que lesdits contacts électriques (4, 5) comportent une extrémité extérieure (70, 73) au boîtier assurant la dissipation thermique par convection de la chaleur engendrées par le composant, l'autre partie (16, 26) du contact électrique assurant la conduction thermique de ladite chaleur jusqu'à ladite extrémité extérieure (70, 73).

2. Boîtier pour composant électronique selon la revendication 1, caractérisé en ce que la partie extérieure (70, 73) des contacts a une forme rectangulaire et se prolonge par deux pattes de connexion (20, 21).

3. Boîtier pour composant électronique selon la revendication 2, caractérisé en ce que les deux pattes de connexion (20, 21) sont dans le prolongement de deux côtés opposés de la partie extérieure rectangulaire (70, 73).

4. Boîtier pour composant électronique selon l'une des revendications 1 à 3, caractérisé en ce que les deux contacts (4, 5) sont disposés verticalement et traversent l'embase à 90° l'un par rapport à l'autre, le premier (4) destiné au contact avec l'électrode inférieure du composant (1) comportant une partie en H, les deux bras inférieurs du H constituant lesdites pattes de connexion (20, 21), ledit premier contact (4) comportant en outre en son milieu une partie sensiblement horizontale (25, 26) venant s'appuyer sur le fond de l'embase (8).

5. Boîtier pour composant électronique selon la revendication 4, caractérisé en ce que le fond de l'embase possède une ouverture (32) permettant la dissipation de la chaleur par le verso de la partie intérieure horizontale du premier contact (4).

6. Boîtier pour composant électronique selon l'une des revendications 4 ou 5, caractérisé en ce que le second contact (5) destiné au contact avec l'électrode supérieure du composant (1) est un contact électrique. pourvu de plusieurs doigts (16).

7. Boîtier pour composant électronique selon la revendication 6, pour un composant pulvérisable par une surintensité ou une surtension entre les deux électrodes, caractérisé en ce que la forme et la dissipation des parties des contacts électriques (4, 5) en contact avec les électrodes du composant (1) sont telles qu'après pulvérisation dudit composant, le circuit est ouvert entre lesdits contacts (4, 5).

8. Boîtier pour composant électronique selon l'une des revendications 4 à 7, caractérisé en ce que les bras supérieurs du H (23, 24) sont destinés au raccordement d'un second composant (2) dont l'autre extrémité est reliée à un troisième contact (6) disposé verticalement à 90° du premier ou du second contact (4, 5).

9. Boîtier pour composant électronique selon la revendication 7, caractérisé en ce qu'il comporte un troisième et un quatrième contacts électriques (6, 7) disposés verticalement à 90° par rapport aux deux premiers (4, 5), lesdits contacts (6, 7) comportant également une extrémité extérieure au boîtier (76, 77) de forme rectangulaire assurant une fonction de dissipation thermique.

## Claims

1. Package of an electronic component (1) comprising two plane opposite faces covered with electrodes, said package comprising a base (8) and a hood (9), said base (8) being crossed by at least one first and one second electric contact (4, 5), the end of these contacts located inside of the package being susceptible of being respectively connected to one electrode of the component (1), characterized in that said electric contacts (4, 5) comprise an end (70, 73) outside of the package and ensuring the thermal dissipation by convection of the heat generated by the component, the other portion (16, 26) of the electric contact ensuring the thermal conduction of said heat to said outer end (70, 73).

2. Package of an electronic component according to claim 1, characterized in that the outer portion (70, 73) of the contacts has a rectangular shape and is extended by two connection pins (20, 21).

3. Package of an electronic component according to claim 2, characterized in that the two connection pins (20, 21) are provided in the extension of two opposite sides of the outer rectangular portion (70, 73).

4. Package of an electronic component according to any of claims 1 to 3, characterized in that the two contacts (4, 5) are arranged vertically and cross the base at 90° with respect to each other, the first (4) contact provided for contacting the lower electrode of the component (1) comprising a H-shaped portion, the two lower legs of the H forming said connection pins (20, 21), said first contact (4) further comprising in its center an essentially horizontal portion (25, 26) applied on the bottom of the base (8).

5. Package of an electronic component according to claim 4, characterized in that the bottom of the base has an opening (32) permitting the dissipation of the heat through the backside of the lower horizontal portion of the first contact (4).

6. Package of an electronic component according to any of claims 4 and 5, characterized in that the second contact (5) provided for contacting the upper electrode of the component (1) is an electric contact provided with a plurality of fingers (16).

7. Package of an electronic component according to claim 6, for a component which is susceptible of being destroyed by excessive intensity or an excessive voltage between the two electrodes, characterized in that the shape and the dissipation of those portions of the electric contacts (4, 5) which contact the electrodes of the component (1) are such that, after the destruction of said component, the circuit is open between said contacts (4, 5).

8. Package of an electronic component according to any of claims 4 to 7, characterized in that the upper legs of the H (23, 24) are adapted to be connected to a second component (2) the other end of which is connected to a third contact (6) arranged vertically at 90° of the first or of the second contact (4, 5).

9. Package of an electronic component according to claim 7, characterized in that it comprises a third and a fourth electric contact (6, 7) arranged vertically at 90° with respect to the two first contacts (4, 5), said contacts (6, 7) likewise comprising an end (76, 77) outside of the housing and having a rectangular shape to ensure a thermal dissipation function.

**Patentansprüche**

1. Gehäuse für ein elektronisches Bauteil (1) mit zwei gegenüberliegenden, mit Elektroden besetzten Seiten, wobei das Gehäuse eine Fußplatte (8) und eine Haube (9) enthält, wobei die Fußplatte (8) von mindestens einem ersten und einem zweiten elektrischen Kontakt (4, 5) durchquert wird, wobei das im Gehäuse gelegene Ende der Kontakte jeweils mit einer Elektrode des Bauteils (1) verbunden werden soll, dadurch gekennzeichnet, daß die elektrischen Kontakte (4, 5) ein außerhalb des Gehäuses gelegenes Ende (70, 73) aufweisen, das durch Konvektion die Wärmeableitung der vom Bauteil erzeugten Wärme erreicht, wobei der andere Teil (16, 26) des elektrischen Kontakts die Wärmeleitung dieser Wärme bis zum äußeren Ende (70, 73) ermöglicht.

2. Gehäuse für ein elektronisches Bauteil nach Anspruch 1, dadurch gekennzeichnet, daß der äußere Teil (70, 73) der Kontakte eine rechteckige Form aufweist und durch zwei Verbindungsstifte (20, 21) verlängert ist.

3. Gehäuse für ein elektronisches Bauteil nach Anspruch 2, dadurch gekennzeichnet, daß die beiden Verbindungsstifte (20, 21) in der Verlängerung der beiden gegenüberliegenden Seiten des äußeren, rechteckigen Teils (70, 73) sind.

4. Gehäuse für ein elektronisches Bauteil nach einem der Ansprüche 1 bis 3, dadurch gekennzeichnet, daß die beiden Kontakte (4, 5) vertikal angebracht sind und die Fußplatte in einem Winkel von 90° zueinander durchqueren, wobei der erste (4), der zum Kontakt mit der unteren Elektrode des Bauteils (1) dient, einen H-förmigen Teil enthält, wobei die unteren Abschnitte des H die Verbindungsstifte (20, 21) darstellen, und wobei der erste Kontakt (4) außerdem in seiner Mitte einen im wesentlichen horizontalen Teil (25, 26) enthält, der gegen den Boden der Fußplatte (8) anliegt.

5. Gehäuse für ein elektronisches Bauteil nach Anspruch 4, dadurch gekennzeichnet, daß der Boden der Fußplatte eine Öffnung (32) besitzt, der die Wärmeabgabe durch die Rückseite des inneren, horizontalen Teils des ersten Kontakts (4) ermöglicht.

6. Gehäuse für ein elektronisches Bauteil nach einem der Ansprüche 4 oder 5, dadurch gekennzeichnet, daß der zweite Kontakt (5), der zum Kontakt mit der oberen Elektrode des Bauteils (1) dient, ein mit mehreren Fingern (16) ausgestatteter elektrischer Kontakt ist.

7. Gehäuse für ein elektronisches Bauteil nach Anspruch 6, für ein durch Überintensität oder Überspannung zerstörbares Bauteil, dadurch gekennzeichnet, daß die Form und die Verteilung der im Kontakt mit den Elektroden des Bauteils (1) stehenden elektrischen Kontakte (4, 5) so sind, daß nach Zerstörung des Bauteils der Schaltkreis zwischen diesen Kontakten (4, 5) offen ist.

8. Gehäuse für ein elektronisches Bauteil nach einem der Ansprüche 4 bis 7, dadurch gekennzeichnet, daß die oberen Abschnitte des H (23, 24) zum Anschluß eines zweiten Bauteils (2) vorgesehen sind, dessen anderes Ende mit einem dritten Kontakt (6) verbunden ist, der vertikal in einem Winkel von 90° zum ersten oder zum zweiten Kontakt (4, 5) angebracht ist.

9. Gehäuse für ein elektronisches Bauteil nach Anspruch 7, dadurch gekennzeichnet, daß es einen dritten und vierten elektrischen Kontakt (6, 7) enthält, die vertikal in einem Winkel von 90° zu den ersten beiden (4, 5) angebracht sind, wobei diese Kontakte (6, 7) gleichermaßen ein Ende (76, 77) enthalten, das außerhalb des Gehäuses gelegen und von rechteckiger Form ist, das eine Funktion des Wärmeabgabe ausführt.

FIG_1

0 142 400

# FIG_2